(19) Europäisches Patentamt
European Patent Office
Office européen des brevets

(11)  EP 2 617 074 B1

(12)  **EUROPEAN PATENT SPECIFICATION**

(45) Date of publication and mention
of the grant of the patent:
**26.04.2017  Bulletin 2017/17**

(51) Int Cl.:
*H01L 41/09* [(2006.01)]    *H01L 41/25* [(2013.01)]
*G01Q 10/04* [(2010.01)]

(21) Application number: **11773859.1**

(22) Date of filing: **13.09.2011**

(86) International application number:
**PCT/IB2011/053997**

(87) International publication number:
**WO 2012/035491 (22.03.2012 Gazette 2012/12)**

(54) **ELECTRO-ACTIVE MICROELECTROMECHANICAL DEVICE AND CORRESPONDING DETECTION PROCESS**

ELEKTROAKTIVES MIKROELEKTROMECHANISCHES BAUELEMENT UND ZUGEHÖRIGES DETEKTIONSVERFAHREN

DISPOSITIF MICROÉLECTROMÉCANIQUE ÉLECTRO-ACTIF, ET PROCÉDÉ DE DÉTECTION CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.09.2010  IT TO20100748**

(43) Date of publication of application:
**24.07.2013  Bulletin 2013/30**

(73) Proprietor: **Fondazione Istituto Italiano Di Tecnologia**
**16163 Genova (IT)**

(72) Inventors:
• **QUALTIERI, Antonio**
**I-73048 Nardò (LE) (IT)**
• **RIZZI, Francesco**
**I-70124 Bari (BA) (IT)**
• **DE VITTORIO, Massimo**
**I-73100 Lecce (LE) (IT)**
• **PASSASEO, Adriana**
**I-73100 Lecce (LE) (IT)**
• **TODARO, Maria, Teresa**
**I-73030 Montesano Salentina (LE) (IT)**

• **EPIFANI, Gianmichele**
**I-73015 Salice Salentino (LE) (IT)**

(74) Representative: **Gallarotti, Franco**
**Buzzi, Notaro & Antonielli d'Oulx**
**Via Maria Vittoria, 18**
**10123 Torino (IT)**

(56) References cited:
**EP-A- 2 309 559        US-A1- 2004 101 150**
**US-A1- 2005 051 515**

• **LAVRIK NICKOLAY V ET AL: "Cantilever transducers as a platform for chemical and biological sensors", REVIEW OF SCIENTIFIC INSTRUMENTS, AIP, MELVILLE, NY, US, vol. 75, no. 7, 1 July 2004 (2004-07-01), pages 2229-2253, XP012071658, ISSN: 0034-6748, DOI: DOI:10.1063/1.1763252**
• **JOSEPH C DOLL ET AL: "Design of piezoresistive versus piezoelectric contact mode scanning probes", JOURNAL OF MICROMECHANICS & MICROENGINEERING, INSTITUTE OF PHYSICS PUBLISHING, BRISTOL, GB, vol. 20, no. 9, 1 September 2010 (2010-09-01), page 95023, XP020182494, ISSN: 0960-1317**

**Description**

The present invention refers to an electro-active microelectromechanical device of the Artificial Hair Cell type, including a moving cilium structure including a substrate and a cantilever, partly or entirely in piezoelectric material, subject to bending or deformation following the action of a force and/or an applied voltage ($V_{appl}$), said cantilever comprising a multilayer that induces a stress-driven geometry in which a portion of said cantilever lies out of a plane defined by the substrate.

In the description that follows reference will be made to a known type of electromechanical device, that comprises cantilevers, obtained through surface micromachining, for example of silicon, constrained at only one of the extremities and free to oscillate at the other extremity in response to solicitations. These are generally known in the technical field of MEMS devices as cantilevers and will be referred to as such in the present description. Likewise, in the present description microextensometry obtained by means of layers of piezoresistive material suitable to measure the bending or deformation of structures, will be referred to as micro strain gauge or strain gauge, the names generally used in the field of MEMS or microelectro-mechanics and of dynamometry.

Electro-active sensing devices are known, for example Artificial Hair Cell (AHC) sensors, used to detect fluid flows. To realize such sensors an approach of the typed used in hot wire anemometers can be used, or an approach based on a movable cilium structure, the bending of which by the motion of the fluid, is detected by an electric reading mechanism. Typically this is obtained using a horizontal cantilever on a rigid substrate, onto which the cilium is placed. The motion of the fluid moves the cilium and the cantilever, the bending of which is detected by a micro extensometer, or micro strain gauge, by reading the corresponding piezoresistance value. The equilibrium position of the cantilever is horizontal and the device can sense the direction of flow, although with a relatively high threshold of detection with respect to solutions that adopt a stress-driven geometry as described below.

**Document** US2005/051515 A1 **discloses a microelectromechanic device including a piezo-electrically actuated cantilever.**

The publication by Zhang et al., Sensors and Actuators A 158 (2010) 273-279), describes a flow sensor based on an auto-bending cantilever obtained through a specific procedure of growing and micromachining. The device is manufactured on a Silicon-On-Insulator (SOI) wafer, exploiting the difference in residual stress between the layers of silicon and silicon oxide. The cantilever is obtained with two layers of silicon oxides, between which a silicon piezoresistor is placed by means of ion implantation. The difference in stress causes upward curving of the cantilever, the free end of which bends out of the plane of the device. When a fluid flow is applied, it bends the already curved cantilever and changes the resistance value of the piezoresistor. A similar configuration is highly sensitive for measuring at low flow and allows the cantilever to be integrated in microchannels for measuring flows at full operation.

Variants of such device that use piezo-active materials are known. For example, the document US 2009/0301196 envisions applying a functionalized layer onto a surface of a flat beam cantilever, which reacts by deforming the cantilever when the target substance is present. If the cantilever is piezoelectric, the deformation can be detected, or a piezoresistor can be applied. Other devices react by bending the cantilever in response to heat or to an external magnetic or electric field.

However, the operation of similar devices is not controlled based on real-time evaluations, since the power of their micro-actuators is chosen a priori. Moreover, the deformation mechanism results from external causes, and therefore is more susceptible to environmental conditions that influence the external control.

The object of the present invention is to overcome the drawbacks of the prior art and, in particular, to obtain a device, in particular an electroactive sensor of the Artificial Hair Cell type including a moving cilium structure, the operation and settings of which are more controllable, also in real time, improving the mechanism of detection.

According to the present invention, such object is achieved by means of a process having the features specifically recalled in the claims that follow, which form an integral part of the present description. The invention concerns also the corresponding detection process.

According to an important aspect of the invention, the process envisions providing a micro-machined cantilever in piezoelectric material comprising a multilayer that operates by stress-driven geometry and is associated to an element in piezoresistive material for measuring bending or deformation.

Due to the above-indicated characteristics, the process according to the invention provides devices with electroactive characteristics attainable and adjustable by virtue of the interaction between the properties of the piezoelectric elements and piezoresistive elements of the moving cilium structure, in particular for the purpose of optimising the range of sensitivity or measuring range of the device.

Further characteristics and advantages of the invention will be clear from the descriptions that follow, made with reference to the annexed drawings, provided by way of non-limiting example only, in which:

-    figure 1 shows schematically a section of the electro-active device according to the invention,
-    figure 2 is a schematic prospective view of said device according to the invention,
-    figure 3 schematically shows the steps in a process for manufacturing the device according to the invention,

- figure 4 schematically shows the steps in a process for manufacturing a variant of the device according to the invention,
- figures 5a, 5b, 5c are operation timing diagrams in a first operational condition of different structural configurations of the device according to the invention;
- figures 6a, 5b, 5c are operation timing diagrams in a first operational condition of different structural configurations of the device according to the invention;
- figures 7 and 8 are further diagrams illustrating the operation of the device according to the invention,
- figure 9 is a diagram of a characteristic working curve of the device according to the invention,
- figure 10 is a diagram of further working curves of the device according to the invention.

Briefly, a device is described, in particular an electro-active Artificial Hair Cell-type sensor device, including a moving cilium structure with a stress-driven geometry, obtained by means of the release of a cantilever through the residual stress and determining a bending of the cantilever, in which the extremity, or suspended part, of the cantilever lies outside the plane of the substrate and is therefore more susceptible to being influenced by inertial forces or aerodynamic or fluidodynamic resistance operating on the sensor. The body of the cantilever comprises a piezoelectric layer, arranged in a sandwich configuration between contact layers, or electrodes, and determines an electro-active behaviour of the sensor, the curvature of the cantilever being controllable, in particular through application of a voltage to such contact layers. In addition, a strain gauge deposited on the upper surface of such cantilever and susceptible of using the piezoresistive effect senses any variation in movement of the cantilever, detecting the mechanical state of the sensor. Through a manufacturing process of such device, which envisions multiple layer deposition and patterning of a piezoresistive metallic foil strain gauge on a piezoelectric substrate, two physical effects are combined together: polarisation of the material in the deformed piezoelectric layer and variation of resistance in the piezoresistance. By virtue of the cantilever bending due to the stress-driven geometry, an applied voltage is determined at the contacts of the piezoelectric layer that varies whenever an external force is applied to the cantilever. At the same time, different piezoelectric values are detected at the strain gauge when the cantilever is bent upward or downward. Using the piezoelectric multilayer as a micro actuator, it is possible to obtain feedback controlled with respect to the piezoresistive reading. In this way, the device according to the invention provides a new electroactive approach to piezoelectric and piezoresistive cantilevers that uncouples piezoresistive detection and the mechanism of piezoelectric actuation. In this way, even if the same external force is applied to the cantilever, it is possible to control the bending, as if there were an internal force that counterbalances or is added to the external bending force, setting the best or the desired reaction of the cantilever to the action of the external force. The device according to the invention, through a structure itself inventive, is able in this way, with respect to the state of the art cilium sensors and actuators, to reproduce in different contexts, the best mechanical deformation characteristics and consequently the best detection of inertial or resistance forces.

By setting the structural and material parameters for the piezoelectric cantilever and for the strain gauge (for example, Young's modulus, Poisson ratio, piezoelectric and piezoresistive coefficients) and setting the geometric parameters of the device (layer thickness, length and width of the cantilever) leads to determination of the slope of the characteristic curve, a linear function that relates the relative variation of piezoresistance and the voltage applied to the piezoelectric layer. On such characteristic curve an intrinsic initial working point of the device can be defined, and, during the measuring procedure, applying an additional voltage at the contacts of the piezoelectric layer, the working point can be moved along the characteristic curve, setting a new working point for measurement or actuation. This allows setting of the range or dynamic field most appropriate for every application, or rather the ratio between the smallest value and the greatest value possible of the relative variation in piezoelectric resistance and of the voltage applied, fixing the centre of such range and avoiding saturation of the signal or mechanical limitation during operation.

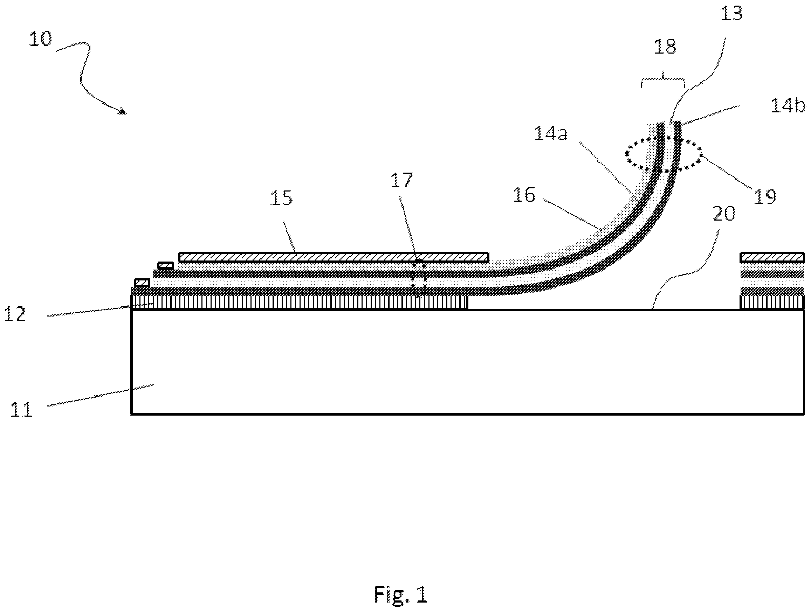

The combined use of the piezoresistance value and the applied voltage, in addition to allowing regulation of the best sensitivity and dynamic working range for each experimental condition, during a flow or inertial force measurement, also allows the use of the proposed devices for realizing an improved cantilever for Scanning Probe Microscopy (SPM), or probe scanning, that completely integrates the actuation mechanism and flexion sensor into the beam. figure 1 shows an electroactive device according to the invention, indicated in its entirety with 10. A silicon substrate 11 carries a sacrificial insulating silicon dioxide layer 12. A cantilever structure indicated with 18 is deposited on the sacrificial insulating layer. Such cantilever 18 has a suspended beam form and includes an anchoring portion 17 at one end, substantially horizontal in contact with the insulating layer 12, while at the other end a portion 19 is suspended above an excavation 20, a zone in which the deposited layers have been removed, in particular the sacrificial insulating layer 12 was removed down to the level of the substrate 11. The suspended portion 19 is shown bent upwards to form a cilium, because the multilayer comprised in the cantilever 18 has a stress-driven geometry.

Thus the cantilever 18 comprises a piezoelectric layer 13 of aluminium nitride, which is included in a sandwich structure of metallic contacts, one contact layer above 14a and one contact layer below 14b, of molybdenum, that function as electrodes for applying voltage to the piezoelectric layer 13. Such applied voltage is indicated below with $V_{appl}$, which is a voltage applied to the piezoelectric contacts, an actuation mechanism for moving the cantilever and applying a force.

The structure of the cantilever 18 is completed with an isolating layer 16 of silicon nitride deposited over the upper contact layer 14a.

On such insulating layer 16 of silicon nitride is also deposited a piezoresistive layer 15, that as will be illustrated better in the following, is shaped in the form of a strain gauge or extensometer.

Thus the electro-active sensor device 10 is a semiconductor micro-electromechanical system (MEMS) whose cantilever geometry self-bending through the residual stress is mounted on the silicon substrate 11, on which also the electrical and detection circuits of the device 10 can be integrated.

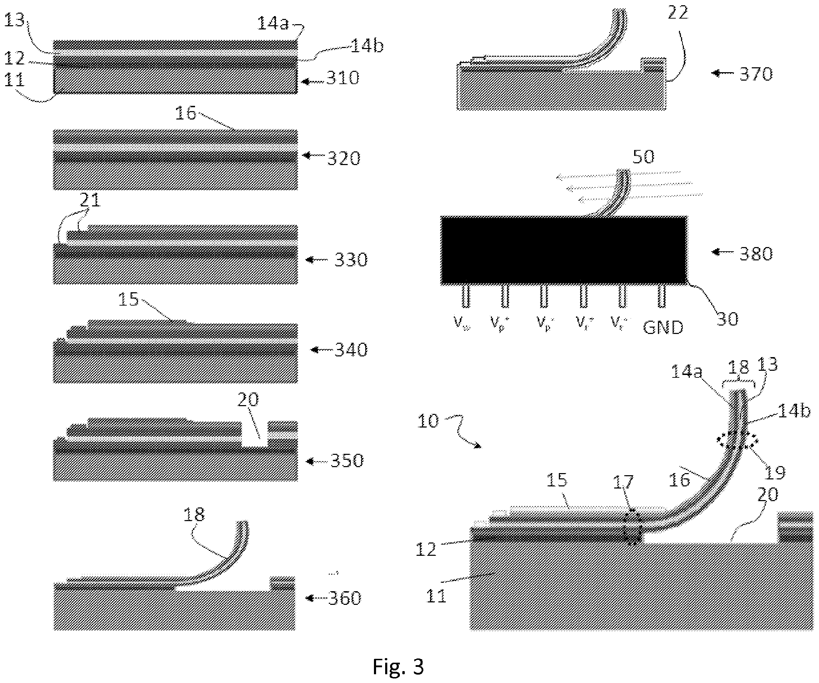

The curved geometry of the cantilever 18 is obtained through stress-driven geometry, derived from its multilayered composite structure. The geometric parameters, curvature and height, of the cantilever in the flexed position can be regulated through the choice of the parameters of the materials in the multilayer of said cantilever 18. This is obtained by growing different materials over the substrate 11, each having a different internal stress linked to different crystal lattices. The residual stress gradient with respect to the thickness of the layers 13, 14a, 14b, and 16 that constitute the cantilever generates the force that causes the upward curvature of the cantilever 18. The degree of bending of the cantilever 18 can be controlled through lithographic patterning to obtain determined dimensions, in particular in plan, of the unreleased cantilever, as well as through control of the thickness of the sacrificial layer 12 to be chemically removed with the aim of releasing the cantilever 18, as well as through the choice of growth parameters such as: substrate temperature, deposition pressure, flow rate of gases involved in the deposition process, continuous polarisation applied to the substrate and the relationship between the thickness of the contacts and that of the piezoelectric layer. When the U-shaped region defining the cantilever 18 is removed by chemical etching of the multilayer, after it has been grown, as is better illustrated in the following with reference to figure 3, followed by removal of the underlying sacrificial layer 12 occupying the area of excavation 20 in figure 1, the unbalanced stress relaxes bending the cantilever 18 upwards. In this way, the cantilever 18 remains anchored to the substrate 11 at its fixed end, the anchoring portion 17, and is bent in the form of a curve on the side of its free end, the suspended portion 19.

The curved cantilever 18, suspended over the substrate 11, maintains a position of equilibrium at a fixed height with respect to the substrate 11. If the cantilever 18 is subjected to a physical force in the direction of its length, it bends, increasing or decreasing its curvature. The strain gauge sensor attached to the cantilever 18, substantially obtained by means of the piezoresistive layer 15, detects the bending or deformation caused by the applied external force: such detection mechanism results from the increase or decrease of a physical property, in particular piezoresistance, with respect to its value in the equilibrium position. Based on this negative or positive variation, the sensor device 10 can distinguish the orientation of the applied force.

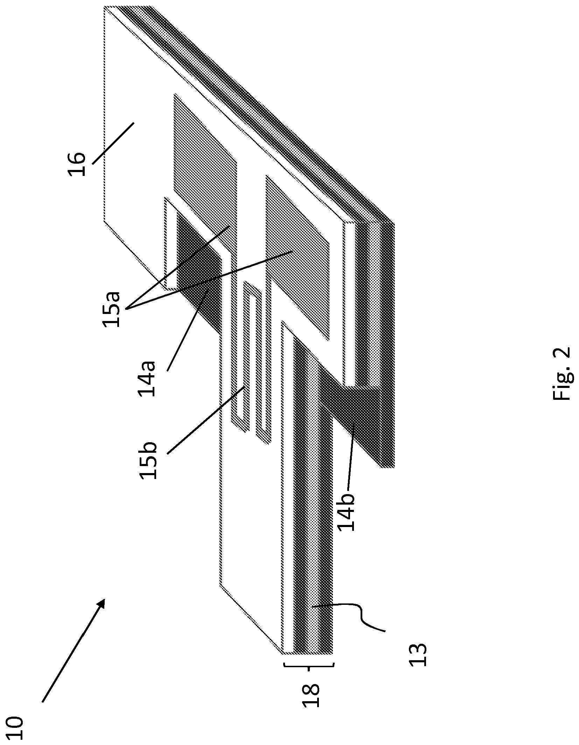

Figure 2 shows a schematic prospective view of a possible embodiment of the contact layers 14a and 14b for the piezoelectric part and of the piezoresistive layer 15 that forms the strain gauge, which comprises a serpentine tract 15b corresponding to a region of articulation, or hinge, of the suspended portion 19 of the cantilever 19, i.e., the region in which the cantilever 18 departs from the plane of the substrate 11, and of the electrical contact patches 15a in the anchorage portion 17 integral to the insulating layer 12 of silicon dioxide.

Thus, the architecture of the device 10 can be used as an electro-active sensor in air or any fluid, combining two physical effects:

- piezoresistance, incorporating/depositing a serpentine shaped piezoresistance, the piezoresistive layer 15, onto the articulation of the beam corresponding to the cantilever 18 as an integral part of the sensor system; with respect to such value, the cantilever 18 can function as a passive system, because an external stimulus, for example, a flow of air, causes a simple variation in the resistance of the strain gauge 15b;
- piezoelectrical, using piezoelectric material for the cantilever 18, so that a mechanical deformation of the system gives rise to an electric field in the cantilever 18, supplying an output voltage value (direct piezoelectric effect), while the application of a voltage to the cantilever 18 causes it to bend due to the piezoelectrical properties, allowing for example the curvature required for a specific application to be reached (inverse piezoelectric effect).

The contacts 15a of the piezoresistance 15 and the contacts 14a, 14b of the piezoelectric cantilever 18 are configured, in particular through interposition of the insulating layer 16, so to permit simultaneous and independent control of the detection and actuation mechanisms. The multilayer composition of the cantilever 18 is configured to insulate the contact layers 14a, 14b, also with respect to the contacts 15a of the piezoresistance 15. The stack consisting of the lower contact layer 14b/ piezoelectric layer 13/ upper contact layer 14a/ insulating layer 16/ piezoresistance 15 must be grown and processed with particular attention to layer thicknesses, which determine the initial curvature of the device 10. Typical thickness values for these layers are in the hundreds of nanometres for the piezoelectric and piezoresistive, as well as for the insulating layers, while the metallic contact layers have thicknesses in the order of tens of nanometres. However, such thickness values are calculated for each specific application, according to the force values to be detected and monitored. In addition, the growing conditions for the layers of preselected materials, cantilever dimensions 18 and the resulting height attained by the end of the suspended portion 19 in flexion, as well as the portion of the strain gauge 15b in the most sensitive zone of the cantilever 18, depend on the intended application.

Applications in hostile environments may require devices with solutions, also packaging, adapted to resisting the conditions found in such environments. In order to avoid problems deriving from large and sudden changes in temperature, the integration of a Wheatstone bridge into the device 10 is envisioned, comprising four identical strain gauges, for example identical to the piezoresistive layer 15 in figure 2, one of which is arranged on the upper surface of the cantilever 18, while the other three are arranged near the first, but are not subjected to mechanical deformation. Thus the four strain gauges are subjected to the same thermal volume variations, balancing the thermal effect. In the case of humid or very dry environments, the device can also be packaged through conformal coating with parylene, or other insulating polymer or resin, to avoid shorting of the integrated circuitry.

In figure 3 the manufacturing operations for the sensor device 10 are shown schematically, in particular for use as a flow or inertial force sensor.

In particular, reference 310 indicates an operation of growing by sputtering on a commercial silicon dioxide on silicon substrate, corresponding to layers 12 and 11 in figure 1, of the following layers, from bottom to top:

    the lower contact layer 14b in molybdenum;
    the piezoelectric layer 13 of aluminium nitride;
    the upper contact layer 14a in molybdenum.

Molybdenum and aluminium nitride constitute a valid combination for use with the same growing technique. Aluminium nitride is easily integrated in silicon-based microsystems. Molybdenum is chosen for reasons linked to growth, in that, during sputter deposition molybdenum assures high quality of aluminium nitride grown in columnar form, amplifying the piezoelectric effect in the vertical direction of growth. The three layers described above form the piezoelectric actuation mechanism for the cantilever 18, when a voltage is applied to it.

Reference 320 indicates an operation of depositing the insulating layer 16 of silicon nitride, with the aim of uncoupling and removing electrical contact between the piezoelectric layer 13 and the piezoresistive layer 15 that forms the strain gauge 15b.

Reference 330 indicates an acid etching step for opening accesses 21 to the upper 14a and lower 14b contact layers, which function as electrodes for the piezoelectric layer 13.

Reference 340 indicates an operation of vapour deposition of the piezoresistive layer 15, that envisions for example evaporating a Nichrome alloy (80% Nickel/20% Chrome), followed by a lithographic lift-off step itself known, with the aim of constructing the piezoresistive strain gauge 15b and the associated Wheatstone bridge.

In the context of the deposition operation 340 shown in figure 3, a step is performed in which metallic contacts are deposited and shaped by means of lift-off, for integration between the device 10 and a printed circuit 30, onto which it is mounted.

Reference 350 indicates the operation of shaping the cantilever 18 through lithography and wet or dry chemical etching, according to which layer among the layers 16, 14, 13 or 12 must be removed;

Then a selective removal step 360 is performed by wet etching of the silicon dioxide layer 12, which serves as a sacrificial layer. Thus, due to the stress-driven geometry, the operating principle of which was illustrated previously, with the removal of the sacrificial insulating layer 12 in a region beneath the cantilever 18, in particular the excavation 20 beneath the suspended portion 19, the cantilever 18 bends progressively upward, assuming the form and height set up through the choice of its parameters.

Reference 370 indicates a step of conformal deposition with a protective layer 22, in particular parylene, to cover the device 10 assuring electrical insulation and adequate packaging both in the presence of dry or humid conditions.

Finally, reference 380 indicates a soldering operation on the printed circuit 30, on which the terminals can be seen for controlling the device 10, including the piezoelectric signal terminals Vp+ and Vp- for the piezoelectric layer 18, the piezoresistance signal terminals Vr+ and Vr- from the piezoresistive layer 15, a terminal for supplying the Wheatstone bridge Vw and a ground reference terminal GND. Monitoring and driving devices are connected to such terminals, in particular for controlling the piezoelectric voltage and measuring the piezoresistance, Which can also be completely or partially integrated in the printed circuit or in the substrate itself.

In figure 3 the complete device 10 is also shown, with all of its major elements indicated, substantially corresponding to the device shown in figure 1.

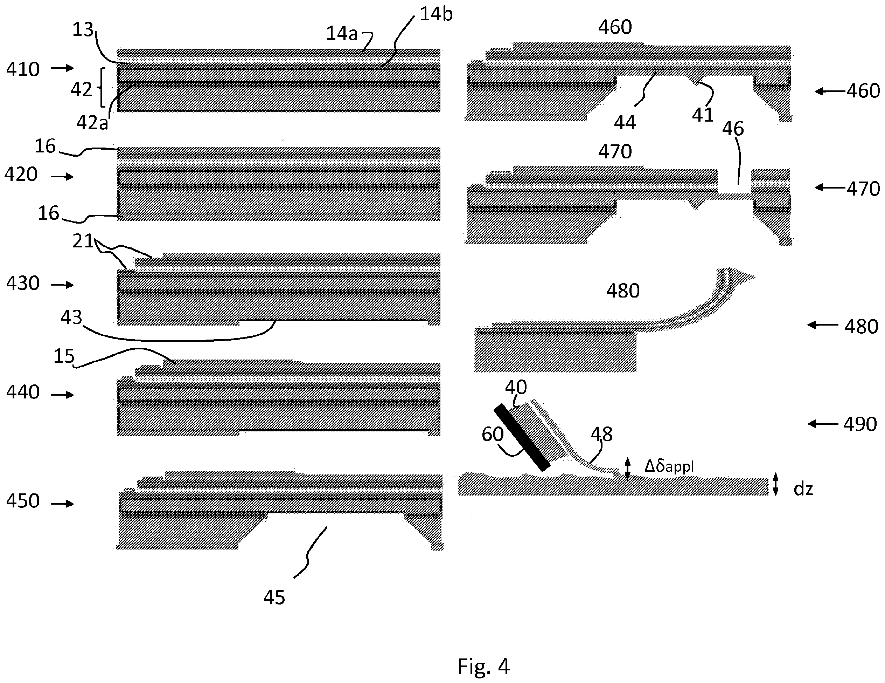

Figure 4 shows the fabrication process for a variant of the device according to the invention, that employs a cantilever 48 adapted to use as an SPM type probe cantilever, in which interaction with forces, for example atomic, of a surface, generally underlying, signalling the magnitude of such force with its movement or deflection and, for example, the geometry of the surface from which it results. Such manufacturing procedure is slightly different in that is uses a Silicon-On-Insulator (SOI) substrate, i.e., silicon-insulator-silicon, and envisions the use of chemical etching on the lower surface of such SOI substrate to manufacture the point, or tip, of the probe and to release the cantilever 48. The materials are chosen with criteria analogous to those illustrated previously in reference to figure 3.

Thus reference 410 indicates an operation of growing, on a commercial silicon SOI substrate 42 that comprises an etch-stop layer 42a of silicon dioxide between the two layers of bulk silicon, and the following sputtered layers, from bottom to top:

the lower contact layer 14b in molybdenum;
the piezoelectric layer 13 of aluminium nitride;
the upper contact layer 14a in molybdenum.

Then an insulating layer 16 of silicon nitride is deposited 420 on both sides of the substrate 11. In this case the silicon nitride is deposited also on the lower side of the substrate 11 as a mask for an acid etching step on such lower side to release the cantilever 48. The materials deposited on the lower side of the substrate 11 as masking material can be substituted if necessary with suitable material for a dry deep etching step on such lower side to release the cantilever 48.

Reference 430 indicates an acid etching step for clearing access 21 to the lower 14b and upper 14a contact layers for the piezoelectric layer 13 on the upper side of the substrate 11 and for opening a window 43 in the insulating layer 16 on the lower side of the substrate 42.

Reference 440 indicates a step of vapour deposition of the piezoresistive layer 15, i.e, a Nichrome alloy, followed by a lithographic lift-off step itself known, with the aim of manufacturing the piezoresistive strain gauge 15b and the Wheatstone bridge. Such operation 440 includes deposition of metallic contacts, shaped by means of lift-off for integration of the device 10 with the printed circuit 30.

Reference 450 indicates the wet acid etching or dry etching step, or a combination of the two, from the bottom on the lower layer of the cantilever 48. Such operation is divided into two steps: in a first step the bulk silicon of the substrate 42 is micro machined; this etching is arrested in correspondence to the insulating $SiO_2$ etch-stop layer 42a and in a second step the $SiO_2$ layer 42a is selectively removed, leaving a lower excavation 45.

A manufacturing operation 460 of a point 41 of the cantilever 48, i.e., a tooth departing from the structural layer 44 and pointing downward, by means of standard acid etching techniques, using $Si_3N_4$ as a masking layer, or by means of more advanced techniques, such as, for example Focused Ion Beam (FIB) etching. Such operation is important for setting the thickness of a structural silicon layer 44, i.e., a support beam, it too cantilevered, obtained from the substrate 42 that remains below the cantilever 48.

Next the cantilever 48 is shaped 470 by means of wet or dry acid etching, according to the layer to be removed; such operation is stopped at the silicon layer 44 below the cantilever 48.

Reference 480 indicates removal of a silicon membrane 46 that remained on the exposed sides of the cantilever 48, selectively removed by means of wet etching; then, due to the previously described stress-driven geometry, with the removal of such membrane the cantilever 48 bends progressively upward, assuming the planned shape and height.

Finally, 490 shows the operative cantilever 48 solder mounted on a Scanning Probe Microscope (SPM) microscope 60. Deflection of the cantilever is indicated with $d\delta_{appl}$, while dz indicates the vertical displacement of the microscope apparatus, as is better illustrated below.

The detection procedure carried out by the device according to the invention will now be illustrated in detail.

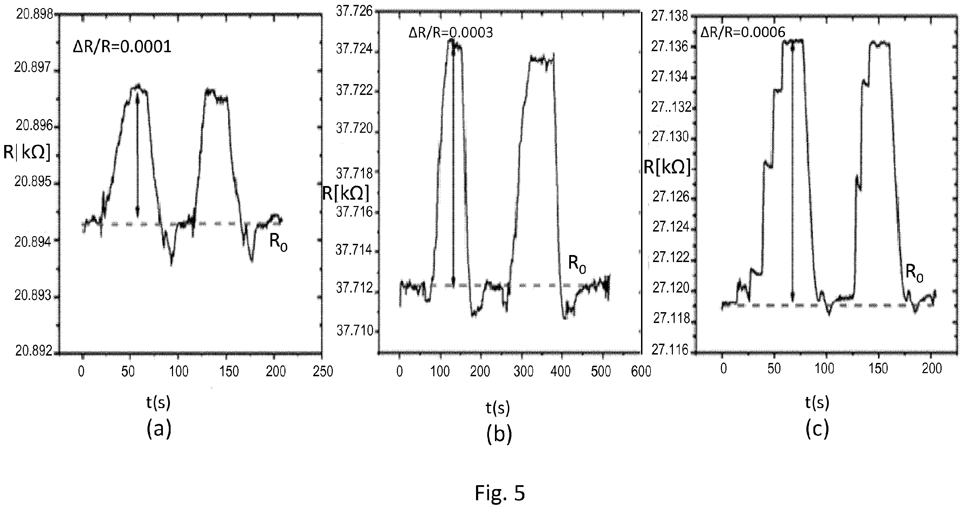

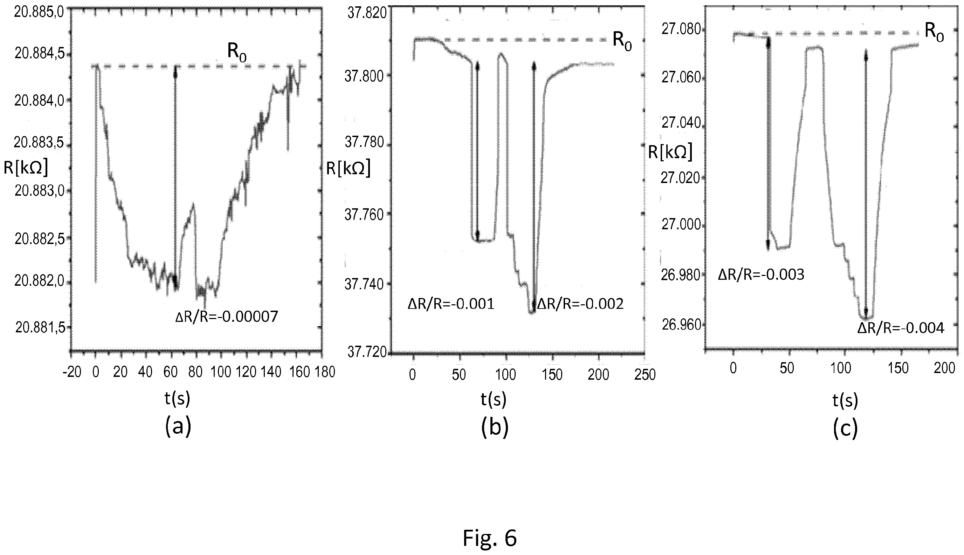

Figures 5a, 5b, 5c, and 6a, 6b, 6c show the variations in the piezoresistance value R of the strain gauge 15 as a function of time t, as a flow of nitrogen 50 is applied to cantilevers with different dimensions. The piezoresistive layer 15 is obtained with a layer of Nichrome alloy 100 nm thick applied to a cantilever 18 with a piezoelectric layer 13 of AlN about 400 nm thick. In figure 5a, 5b, 5c a flow of nitrogen 50, applied at a maximum pressure of 0.3 bar, arriving from the front side of the cantilever 18, i.e., striking first the suspended portion 19, while in figures 6a, 6b, 6c the flow of nitrogen 50 strikes the cantilever 18 from behind. A voltage of 5V is applied $V_{appl}$ between the contact layers 15a.

The respective diagrams a) b) and C) show the trend of the piezoresistance R as a function of time for three different cantilever lengths Lc, length of the strain gauge Lp and equivalent resistance Re of the strain gauge 15, a) Lc=600 $\mu$m, Lp=60 $\mu$m, Re=20,9 k$\Omega$; b) Lc=600 $\mu$m, Lp=120 $\mu$m, Re=37 k$\Omega$; c) Lc=800 $\mu$m, Lp=80 $\mu$m, Re=27 k$\Omega$, respectively. From these diagrams one can easily deduce how a relative variation $\Delta R/R$ in piezoresistance R, i.e., increment or decrement, with respect to equilibrium or resting $R_0$ indicated in the figure by a broken horizontal line, depends on the orientation of the flow 50, allowing it to be identified.

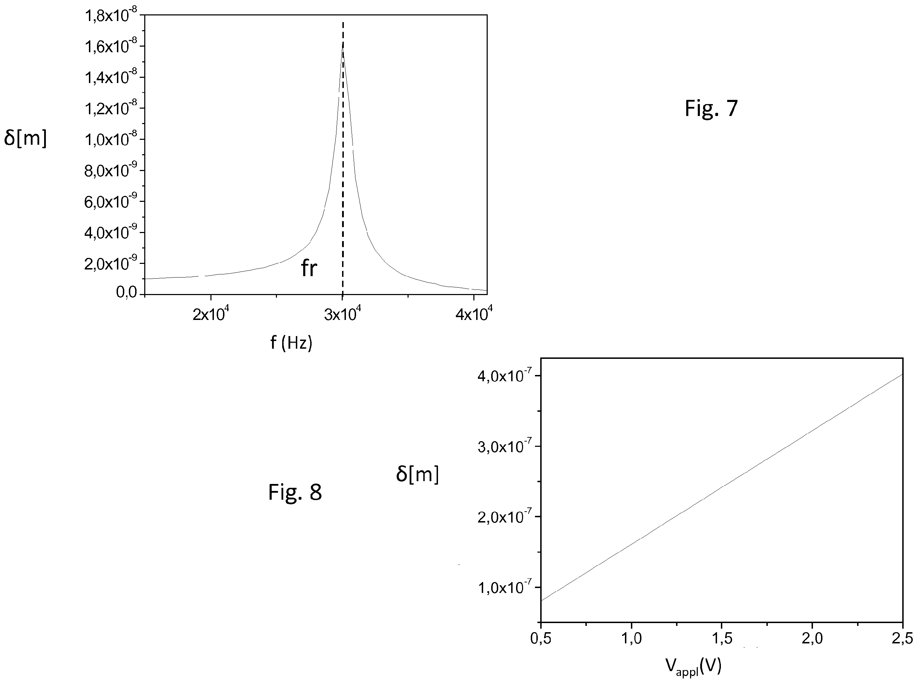

In figures 7 and 8, for the purpose of detailing how the active control of the cantilever 18 functions the diagrams show a deflexion $\delta$ of the end of the cantilever 18, which can also correspond to deflexion of the point 41, as a function of the applied voltage $V_{appl}$, i.e., the voltage applied to the electrodes, as a function of a frequency f of such applied voltage $V_{appl}$ and of the amplitude of the applied voltage $V_{appl}$.

In particular, an alternating voltage is applied to the metallic molybdenum contact layers 14a and 14b, between which the piezoelectric AlN layer is located. In figure 7 the frequency f is varied, maintaining the amplitude of the applied voltage $V_{appl}$ constant at 0.1V: at a resonance frequency fr, in this case 30 kHz, the amplitude of the deflection 5 is maximised. In figure 8 the frequency f is maintained constant at the resonance frequency fr, 30kHz, while the amplitude of the applied voltage $V_{appl}$ is varied between 0.5 V and 2.5 V. The deflection values vary from 2 nm and 16 nm at fixed voltage amplitude, but is from 100 nm to 400 nm when operating at the resonance frequency and modulating the amplitude of the applied voltage $V_{appl}$. Variation of the resting height, achieved through the flexion mechanism, depends on the design characteristics of the cantilever 18, suitable to reproduce the best mechanical characteristics to improve the field of dynamic sensitivity in the context of the specific applications.

An analytical model susceptible of being applied to the device according to the invention will now be described.

As was mentioned previously and is detailed below, the device according to the invention has a characteristic curve on which an intrinsic initial working point of the device can be defined, while, during the measuring procedure, applying an additional voltage to the contacts of the piezoelectric layer, the working point can be moved along the characteristic curve, setting a new working point for measurement or actuation. In the following references denoted by an apex (') denote sizes linked to such new initial working point, i.e., they are the updated values following the application of $\Delta V_{appl}$.

Thus the cantilever 18 is shown schematically as being essentially composed of the piezoelectric layer 13, by its contact layers 14a and 14b and by an elastic layer 16, in addition it is supposed that the cantilever 18 is at rest horizontally or only slightly flexed. Applying the Stoney equation, which describes the flexion $\Delta\delta$ of the free end of the cantilever as a function of the total stress $\sigma$ of the multilayer that comprises it, as well as the DeVoe model, which describes the relationship between a difference in voltage $\Delta V_{appl}$ applied to the piezoelectric electrodes, i.e., the layers 14a and 14b, with respect to a reference voltage $V_0$ (the value of which is 0 V at rest) and the consequent deflection $\Delta\delta$ (direct piezoelectric effect), in the event that a strain gauge is attached to the piezoelectric cantilever 18 one can consider the relative variation of resistance $(\Delta R/R)_0'$ under voltage, with the applied voltage $\Delta V_{appl}$ present on piezoelectric layer 13.

$$(\Delta R/R)_0' = [(18\ \underline{k}\ \beta\ (GF)\ L^3\ d_{31})/(W\ E_{eq}\ t_{eq}^2)][\Theta\ /\ (E_{eq}\ t_{eq}^2)]\Delta V_{appl}\ +\ (\Delta R/R)_0$$

$$(1)$$

L and W indicate length and width of the cantilever 18, respectively, $\underline{k}$ indicates the elasticity constant of the cantilever 18, $d_{31}$ indicates the transversal piezoelectric coupling coefficient, $t_{eq}$ indicates the overall thickness of the beam, $E_{eq}$ indicates the effective Young's modulus of the cantilever. A correction factor $\Theta/E_{eq}$ accounts for the multilayer structure; GF indicates a gauge factor and $\beta$ is a correction factor that accounts for the geometry of the piezoresistance. R is the piezoresistance. $(\Delta R/R)_0'$ indicates the relative variation of resistance, which is always in reference to the resistance when the cantilever 18 is extended in a horizontal position, while $(\Delta R/R)_0$ indicates its value at rest, i.e., the variation in piezoresistance at rest with respect to the value when flat, in the absence of applied voltage $\Delta V_{appl}$ at the contacts 14a, 14b of the piezoelectric layer 13 and originating only from the deflection of the cantilever at rest.

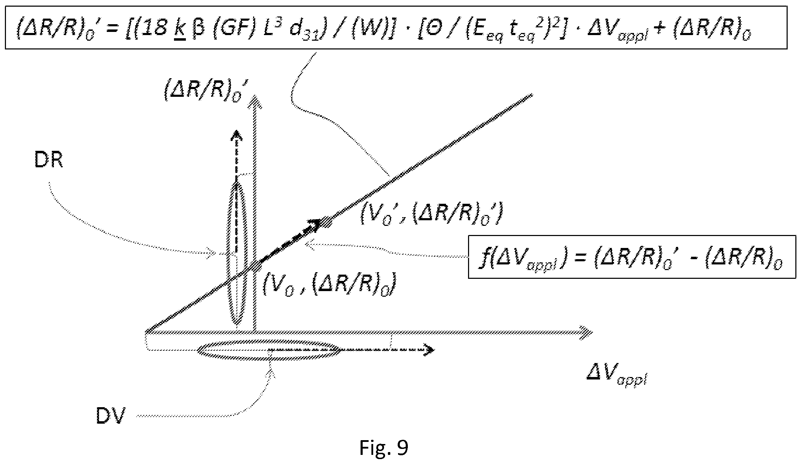

The preceding equation defines a 'characteristic curve' of the device, i.e., a linear function that relates the relative variation of resistance $(\Delta R/R)_0'$ under voltage and the difference in applied voltage $\Delta V_{appl}$ with respect to the voltage at rest $V_0$. The slope f of such characteristic curve $(\Delta R/R)_0'$ $(\Delta V_{appl})$, which is shown in figure 9 and is indicated also as a recalibration function $f(\Delta V_{appl})=f\cdot\Delta V_{appl}$, depends on the structural parameters of the materials, e.g., their Young's modulus, Poisson ratio, piezoelectric and piezoresistance coefficients, as well as on design parameters, such as the layer thicknesses, length and width of the cantilever.

In figure 9 the reference DR indicates the dynamic range of relative variations in resistance $(\Delta R/R)_0'$ calculated with respect to the new initial working point, and DV indicates the range of variations in the differences in voltage applied $\Delta V_{appl}$.

At rest, the multilayer cantilever 18 has a residual stress $\sigma_0$ and a consequent initial deflection $\delta_0$: such values determine an intrinsic initial value of the relative variation of resistance $(\Delta R/R)_0$ at rest, i.e., an intrinsic initial working point $(V_0, (\Delta R/R)_0)$. It is possible to change the intrinsic initial working point by applying an additional voltage $\Delta V_{appl}$, to the contacts of the piezoelectric layer 13. In this way it is possible to set a new initial working point $(V_0', (\Delta R/R)_0')$, where:

$$V_0 \rightarrow V_0' = V_0 + \Delta V_{appl}$$

$$(2)$$

$$(\Delta R/R)_0 \rightarrow (\Delta R/R)_0' = (\Delta R/R)_0 + [(18 k \beta (GF) L^3 d_{31}) / (W)] \cdot [\Theta / (E_{eq} t_{eq}^2)^2] \cdot \Delta V_{appl} = (\Delta R/R)_0 + f(\Delta V_{appl})$$

$$(3)$$

where f($\Delta$V) indicates the recalibration function.

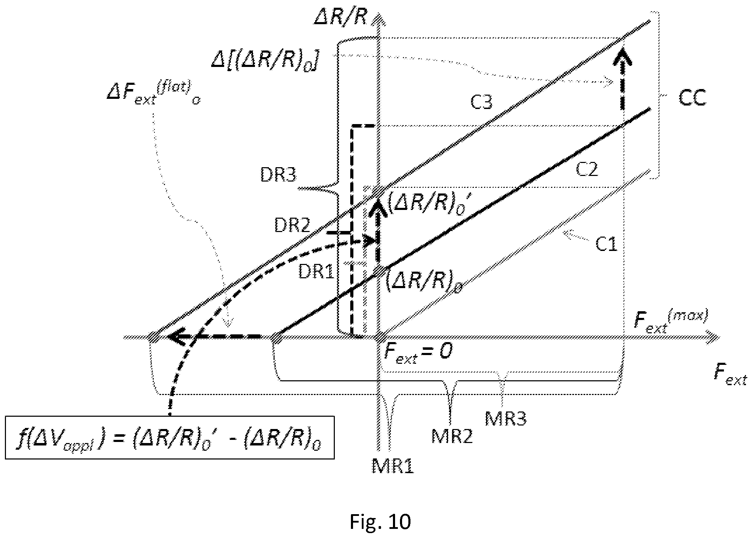

The diagram in figure 10 shows the relative variations in resistance ($\Delta$R/R) as a function of an external force $F_{ext}$ operating on the cantilever 18. The application of an external force $F_{ext}$ on the surface of the cantilever 18 and/or of an additional voltage $\Delta V_{appl}$ applied to the piezoelectric contacts 14a, 14b determine a set CC of calibration curves $\Delta R/R(F_{ext})$:

$$(\Delta R/R) = [(6\beta (GF) L) / (E_{eq} W t_{eq}^2)] F_{ext} + (\Delta R/R)_0 + f(\Delta V_{appl})$$

$$(4)$$

In figure 10 three different calibration curves are shown, C1, C2, C3 with respective measuring ranges MR1, MR2, Mr3 for the force and respective dynamic ranges DR1, DR2, DR3 within which the relative variation in resistance ($\Delta$R/R) varies.

The curve C1 corresponded to a flat or horizontal cantilever, the curve C2 at the initial working point ($V_0$, $(\Delta R/R)_0$)), and the curve C3 at the new initial working point ($V_0'$, $(\Delta R/R)_0'$)). As can be seen, given a certain measuring range, the calibration curve can be moved, acting on the initial working point, and therefore in the final analysis acting on the applied voltage, to obtain the best dynamic range for a measuring range fixed a priori or to set the measuring range for a given dynamic range of relative variation in piezoresistance.

In a preferred embodiment of the device according to the invention in which it functions as a sensor of forces, for example caused by fluid flow or inertial forces, it is envisioned to fix a new initial working point ($V_0'$, $(\Delta R/R)_0'$)), before or during the measurement, through control of the applied voltage, as shown in figure 10, that determines the best or desired dynamic range for a given measuring range and/or to avoid saturation or mechanical limitations during the operation. Based on the preceding equations, a relationship of extension $\Delta V_{appl}$ due to application of the additional voltage $\Delta V_{appl}$ on the piezoelectric layer 13 for the measuring range, also extension rate of the force measuring range, is:

$$\Delta F_{ext}^{(flat)}{}_0 / \Delta V_{appl} = - [3/4 (W t_{eq} d_{31} \Theta) / L]$$

$$(5)$$

where $F_{ext}^{(flat)}{}_0$ indicates the external force to render the cantilever horizontal, i.e., obtain that $\Delta R/R = 0$, for a given calibration curve.

Analogously, if the maximum force applied is fixed at a maximum force value $F_{ext}^{(max)}$, the corresponding rate of extension of the dynamic range is given by:

$$\Delta [(\Delta R/R)_0] / \Delta V_{appl} = (9/2 \beta E_{eq} t_{eq} (GF) d_{31}) [\Theta / (E_{eq}^2 t_{eq}^2)]$$

$$(6)$$

By way of example, for a device according to the invention with the following parameters:

- piezoelectric layer 13 of AlN: thickness 600 nm; Young's modulus 340 GPa, dielectric coefficient -2 pC/N;
- piezoelectric contact electrodes 14a, 14b in Mo (x2): thickness 50 nm; Young's modulus 330 GPa;
- elastic layer in $Si_3N_4$: thickness 300 nm; Young's modulus 240 GPa;
- piezoresistance in Nichrome: Gauge Factor 2.1,

we see that each volt applied provides a relative variation of resistance equal to 7.6 x $10^{-6}$ multiplied by the $\beta$ factor connected to the geometry of the piezoresistive strain gauge 15. If silicon is used for the structural layer 44 of the cantilever 18, with a thickness of 2 $\mu$m and a Young's modulus of 185 Gpa, each volt applied provides a variation in relative resistance of 6.5 x $10^{-6}$ multiplied by the $\beta$ factor. Supposing for simplicity that the $\beta$ factor is 1, based on the preceding equations every time that the working point in resting voltage $V_0$ is moved applying an additional voltage

$\Delta V_{appl}$ = 1 V on the contacts 14a, 14b of the piezoelectric layer 13, the initial working point undergoes a relative variation of resistance $\Delta[(\Delta R/R)_0] \approx 7 \times 10^{-6}$, i.e., an extension rate of the dynamic range of $\approx 7 \times 10^{-6}$ / Volt is obtained and a relative rate of extension of the measuring range of force of $\approx 60$ nN / Volt. It is clear that operating on the parameters of the layers of the cantilever 18 and the geometry of the strain gauge 15, increasing the $\beta$ factor, better results than those reported here by way of example only can be obtained. By way of further example, with reference to the first cantilever in figure 5a or 6a, with a length Lp of the piezoresistance of 60 $\mu$m and equivalent resistance Re $\approx 21$ k$\Omega$, by applying 10 Volts the dynamic range is doubled.

A further application of the device according the invention envisions use of the cantilever, in this case preferably cantilever 48 in figure 4, according to the invention for a new Scanning Probe Microscopy (SPM) technique, which employs the above-described function. Equipping the suspended portion of the cantilever 48 with a point 41, as shown in figure 4, it can be used as a probe: every variation in surface morphology causes a deflection of the point 41 and a variation of the relative resistance in the strain gauge 15. In addition, introduction of the piezoelectric layer 13 in the cantilever 48 obtains a new type of cantilever that has an integrated actuation mechanism. the piezoelectric actuation mechanism serves the purpose of applying a controlled force to the sample. Once the point 41 of the cantilever 48 interacts with the surface of a sample to probe, the application of an additional continuous voltage to the contacts of the piezoelectric layer 13 allows manoeuvring of the cantilever upward or downward. In the known atomic force microscopes, the deflection mechanism in the Z direction is inserted in a piezoelectric scanner that is separate from the cantilever itself. Instead, the structure according to the invention results in a probe in which the mechanism of vertical deflection, indicated with $\Delta\delta_{appl}$ in figure 4, is actively controlled by the piezoelectric properties of the cantilever. The probe according to the invention with the integrated piezoelectric movements can be combined equally well with the external scanner, whose vertical deflection dz is also represented in figure 4, to obtain better control of the applied force and eliminate scanner aberrations.

In the known SPM apparatus, the "force spectroscopy" mode is based on studying the cantilever deflection with respect to variations in the height of the external scanner. With the device according to the invention, there is active control of the force applied by the cantilever point on the sample, resulting in an active Force Spectroscopy mode.

Calculation of the elastic constant $\underline{k} = [(E_{eq} W t^3) / (4 L^3)]$, where $E_{eq}$ is the effective Young's modulus of the entire cantilever, is obtained applying a voltage signal alternating in a frequency range, obtaining the resonance frequency $\omega_0 = \sqrt{(\underline{k}/m)}$ and consequently the elastic constant $\underline{k}$. It follows that the calibration function of the applied force $F_{appl}$ as a function of the applied voltage $\Delta V_{appl}$:

$$F_{appl} = (3\ L^2\ \underline{k}\ d_{31})\ [\Theta\ /\ (E_{eq}\ t_{eq}^2)]\ \cdot\ \Delta V_{appl} \qquad (7)$$

Such calibration function of the force $F_{appl}$ depends only on design and materials parameters. Applying a voltage $\Delta V_{appl}$, an additional force $F_{appl}$ can be exerted and the deflection $\Delta\delta_{appl}$ of the cantilever measured through the relative variation of resistance in the strain gauge 15:

$$\Delta\delta_{appl} = [(W\ E_{eq}\ t_{eq}^2)\ /\ (6\ \beta\ \underline{k}\ (GF)\ L)]\ \cdot\ [(\Delta R/R)_{appl}$$
$$-\ (\Delta R/R)_{eng}] \qquad (8)$$

where $(\Delta R/R)_{eng}$ indicates the relative variation of the piezoresistance corresponding to the interaction of the probe with the sample and provides a measure of the attractive force "Jump to contact".

After the cantilever contacts the sample, the deflection of the cantilever based on the applied force allows measurement of the nanoindentation, providing information on the nano mechanical properties of the sample being scanned in the nanonewton range. Varying the value and polarity of the additional voltage $\Delta V_{appl}$, the resulting sign of the derivative of the variation in relative resistance provides information on the direction of cantilever 48 bending, if it is moving closer or farther away in the context of the "force spectroscopy" measurement or experiment, and allows "force pulling" experiments to be performed on the molecule. If additional voltage is not applied $\Delta V appl$ to the piezoelectric contacts 14a, 14b, the cantilever 48 operates as a simple force sensor and the combination with the variations in height dz of the external scanner assures execution of traditional SPM spectroscopy measurements in "force spectroscopy mode". An alternating force can be applied to the sample, implementing an alternating voltage to the piezoelectric contacts 14a, 14b: this results in an SPM technique in Tapping Mode, in which the cantilever is made to oscillate, in particular near the resonance frequency. Designing the structure of the cantilever 48 with an appropriate elastic constant $\underline{k}$ and applying a controlled force $F_{appl}$, it is also possible to obtain a Writing Mode for writing on soft materials. In conclusion, there is active control of the force applied to the point 41 on the sample, obtaining the Active Force Spectroscopy mode. Using the above-described equations, from the force calibration function $F_{appl}$ ($\Delta V_{appl}$) for each volt

applied it is possible to obtain, for example, the application of a force of about 60 nN on the sample.

Therefore, the proposed process and device allow application of a voltage $\Delta V_{appl}$ to said multilayer of the cantilever 48 to apply a controlled force $F_{appl}$ on a sample to probe and independently measuring a vertical deflection $\Delta \delta_{appl}$ in order to perform measurements of the "force spectroscopy mode" type or of the "nanoindentation" type without the aberrations introduced by the traditional external scanner system.

Thus, the advantages of the device described above are clear.

By virtue of the stress-driven geometry, the device is sensitive to directions and to low intensity forces. The use of piezoelectric mechanism, instead of other control mechanisms, allows more stable control of the electro-active properties of the sensor, also in hostile environments, and an optimal integration with internal circuits and device-hardware interfaces.

Advantageously, the device according to the invention, by means of the combination of piezoelectricity and piezoresistance, allows regulation and adjustment of cantilever properties during measuring operations.

Advantageously, whenever used as a micro-actuator in hostile environments, the device according to the invention performs better, in that the piezoelectric mechanism is more reliable than mechanisms actuated externally by electrostatic or magnetic means, or through thermal deformation.

The device according to the invention, whenever used in Scanning Probe Microscopy (SPM) applications, has a vertical deflection mechanism integrated in the cantilever, unlike the known art solutions, such as atomic force microscopes (AFM) where the mechanism for the z direction is in a piezoelectric scanner separate from the cantilever.

Naturally, without prejudice to principle of the finding, the details of construction and the embodiments may vary, even appreciably, with reference to what has been described and illustrated by way of example only, without departing from the scope of the present invention.

The proposed sensor can be employed in a wide variety of applications, including the design and production of prostheses, Artificial Underwater Vehicles (AUV) and SPM microscopy. The possibility of regulating the dynamic sensibility range allows specific uses for exploring underwater environments, biological research, detection of underwater mines. As a microactuator, the microscopic action of the cantilever allows microscopic movements in Lab On Chip and manipulation of micro objects.

**Claims**

1. Electroactive microelectromechanical device of the Artificial Hair Cell type, including a moving cilium structure including a substrate (11, 12; 42) and a cantilever (18; 48), partly or entirely in piezoelectric material, subject to bending or deformation in response to the action of an external force and/or an applied voltage ($V_{appl}$), said cantilever (18; 48) including a multilayer (13, 14a, 14b, 16) inducing a stress-driven geometry through a residual stress gradient with respect to the thickness of the layers comprised in said multilayer (13, 14a, 14b, 16) in which a portion (19) of said cantilever (18; 48) lies outside of a plane defined by the substrate (11, 12; 42), wherein said cantilever (18; 48) is associated to a piezoresistive element (15), in particular of piezoresistive material, configured to measure the bending or deformation of said cantilever (18; 48).

2. Device according to claim 1, **characterized in that** said piezoresistive element (15) includes a piezoresistive layer comprising a portion (15b) shaped to operate as a strain gauge device.

3. Device according to claim 1 or 2, **characterized in that** said cantilever (18; 48) includes:

   a piezoelectric layer (13), comprised in a sandwich structure of contact metal layers (14a, 14b) suitable to operate as electrodes to apply a voltage to said piezoelectric layer (13), and
   an insulation layer (16) laying upon an upper layer (14a) of said contact layers (14a, 14b), and **in that** said piezoresistive layer (15) is placed on said cantilever (18) in a region subject to bending or deformation.

4. Device according to any of the preceding claims, **characterized in that** said piezoresistive element (15) is included in a Wheatstone bridge structure of piezoresistive elements adapted to compensate thermal variations.

5. Device according to any of the preceding claims, **characterized in that** the contact layers (14a, 14b) of the piezoelectric layer (13) and contacts (15a) of the piezoresistive layer (15) are associated to circuital means (30) configured to control piezoelectric signals (Vp), in particular an applied voltage ($\Delta V_{appl}$) applied to said piezoelectric layer (13), and to measure piezoresistance values (R) of said piezoresistive layer (15).

6. Device according to any of the preceding claims, **characterized in that** a suspended portion (19) of said cantilever (48) includes a supporting beam (44) obtained by the substrate (42), said supporting beam (44) including a tip (41) at the end.

7. Method for detecting physical quantities for use with the device of any of claims 1 to 6 **characterized by** subjecting said cantilever (18; 48) to the action of a force adapted to cause its bending or deformation, measuring a corresponding relative resistance variation (($\Delta R/R$)) of the piezoresistive layer (15), applying, before or during said measuring operation, an additional voltage ($\Delta V_{appl}$) to said piezoelectric layer (13).

8. Method according to claim 7, **characterized in that** includes applying an additional voltage ($\Delta V_{appl}$) to said piezo-electric layer (13) to shift a respective initial working point ($V_0$, ($\Delta R/R)_0$)) and adjusting a dynamic range and/or sensitivity interval or measurement range.

9. Method according to claim 7 or 8, **characterized in that** said cantilever (48) is included in a probe (60) for Scanning Probe Microscopy.

10. Method according to claim 9, **characterized in that** includes applying a voltage ($\Delta V_{appl}$) to said multilayer of the cantilever (48) to apply a controlled force ($F_{appl}$) on a sample to probe and independently measuring a vertical deflection ($\Delta \delta_{appl}$) in order to, in particular, to perform measurements of the "force spectroscopy mode" type or of the "nanoindentation" type without the aberrations introduced by the external scanner system.

11. Method according to one or more of the previous claims, **characterized in that** envisages applying to the piezoelectric layer (13) an alternate voltage, in particular at a resonant frequency (fr; $\omega_0$) of said cantilever (18; 48).

12. Method according to claim 10 or 11, **characterized in that** includes applying a controlled force ($F_{appl}$) for a sensing application, in particular scanning probe microscopy in Tapping Mode, or for microactuation on the sample, in particular scanning probe in Writing Mode.

13. Method for manufacturing the device according any of claims 1 to 6 **characterized in that** includes the operations of:

   growing (310; 410) on a substrate (11, 12) in sequence a bottom contact layer (14b), the piezoelectric layer (13), the upper contact layer (14a), in order to form a cantilever structure (18; 48)
   depositing (320; 420) an insulation layer (16),
   depositing (340; 440) a piezoresistive layer (15) forming a strain gauge device (15a),
   shaping (350; 450) said cantilever (18, 48) by a chemical etching and performing a selective removal (360; 460) of a sacrificial layer (12) of said substrate (11, 12) to cause the release of the cantilever (18;48) and an auto-bending through the residual stress.

14. Method according to claim 13, **characterized in that** includes using a SOI (Silicon On Insulator) substrate (42), comprising, between two bulk semiconductor layers, an insulating stop layer (42a) and **in that** said operations of shaping (450) said cantilever (18; 48) by a chemical etching and performing a selective removal (460) of a sacrificial layer (12) of said substrate (11, 12) include performing etching (430, 450) on a lower surface of said SOI substrate to define a tip (41) of the cantilever (48) and a supporting structure (44) of the cantilever (45).

**Patentansprüche**

1. Elektroaktives mikroelektromechanisches Bauelement der Kunsthaarzellenart, die eine bewegliche Wimpernstruktur mit einem Substrat (11, 12; 42) und einem Ausleger (18; 48) teilweise oder vollständig in piezoelektrischem Material aufweist, die einer Biegung oder Verformung in Reaktion auf die Wirkung einer äußeren Kraft und/oder einer an-gelegten Spannung ($V_{appl}$) ausgesetzt sind, wobei der Ausleger (18; 48) eine Mehrfachschicht (13, 14a, 14b, 16) aufweist, die eine durch einen Spannungszustand angetriebene Geometrie durch ein Restspannungsgefälle mit Bezug auf die Dicke der Schichten aufweist, die in der Mehrfachschicht (13, 14a, 14b, 16) enthalten sind, in der ein Teil (19) des Auslegers (18; 48) außerhalb einer Ebene liegt, die durch das Substrat (11, 12; 42) definiert ist, wobei der Ausleger (18; 48) mit einem piezoresistiven Element (15), insbesondere aus piezoresistivem Material verbunden ist, das konfiguriert ist, um die Biegung oder Verformung des Auslegers (18; 48) zu messen.

2. Bauelement nach Anspruch 1, **dadurch gekennzeichnet, dass** das piezoresistive Element (15) eine piezoresistive Schicht aufweist, die einen Teil (15b) umfasst, der geformt ist, um als eine Dehnmessvorrichtung zu wirken.

**3.** Bauelement nach Anspruch 1 oder 2, **dadurch gekennzeichnet, dass** der Ausleger (18; 48) aufweist:

eine piezoelektrische Schicht (13), die in einer Sandwich-Struktur aus Kontaktmetallschichten (14a, 14b) enthalten ist, geeignet, um als Elektroden zu wirken, so dass eine Spannung an die piezoelektrische Schicht (13) angelegt wird, und
eine Isolationsschicht (16), die auf einer oberen Schicht (14a) der Kontaktschichten (14a, 14b) liegt, und dass die piezoresistive Schicht (15) auf dem Ausleger (18) in einem Bereich platziert wird, der der Biegung oder Verformung ausgesetzt ist.

**4.** Bauelement nach einem der vorhergehenden Ansprüche, **dadurch gekennzeichnet, dass** das piezoresistive Element (15) in einer Wheatstone-Brückenstruktur von piezoresistiven Elementen enthalten ist, die angepasst sind, um thermische Veränderungen zu kompensieren.

**5.** Bauelement nach einem der vorhergehenden Ansprüche, **dadurch gekennzeichnet, dass** die Kontaktschichten (14a, 14b) der piezoelektrischen Schicht (13) und Kontakte (15a) der piezoresistiven Schicht (15) mit Schaltungseinrichtungen (30) verbunden sind, die konfiguriert sind, um piezoelektrische Signale (Vp), insbesondere eine angelegte Spannung ($\Delta V_{appl}$) zu steuern, die an die piezoelektrische Schicht (13) angelegt wird, und um Piezowiderstandswerte (R) der piezoresistiven Schicht (15) zu messen.

**6.** Bauelement nach einem der vorhergehenden Ansprüche, **dadurch gekennzeichnet, dass** ein schwebendes Teil (19) des Auslegers (48) einen Stützträger (44) aufweist, der von dem Substrat (42) stammt, wobei der Stützträger (44) eine Spitze (41) am Ende aufweist.

**7.** Verfahren zur Detektion physikalischer Mengen zur Anwendung mit dem Bauelement nach einem der Ansprüche 1 bis 6, **gekennzeichnet durch**:

Aussetzen des Auslegers (18; 48) der Wirkung einer Kraft, die angepasst ist, um seine Biegung oder Verformung zu bewirken,
Messen der entsprechenden relativen Widerstandsänderung (($\Delta R/R$)) der piezoresistiven Schicht (15),
Anlegen vor oder während des Messvorgangs einer zusätzlichen Spannung ($\Delta V_{appl}$) an die piezoelektrische Schicht (13).

**8.** Verfahren nach Anspruch 7, **dadurch gekennzeichnet, dass** es das Anlegen einer zusätzlichen Spannung ($\Delta V_{appl}$) an die piezoelektrische Schicht (13), um einen jeweiligen anfänglichen Arbeitspunkt ($V_0$, ($\Delta R/R$)$_0$)) zu verschieben, und das Anpassen eines dynamischen Bereiches und/oder eines Sensitivitätsintervalls oder eines Messbereiches aufweist.

**9.** Verfahren nach Anspruch 7 oder 8, **dadurch gekennzeichnet, dass** der Ausleger (48) in einer Sonde (60) für die Rastersondenmikroskopie enthalten ist.

**10.** Verfahren nach Anspruch 9, **dadurch gekennzeichnet, dass** es das Anlegen einer Spannung ($\Delta V_{appl}$) an die Mehrfachschicht des Auslegers (48) aufweist, um eine gesteuerte Kraft ($F_{appl}$) auf eine Probe auszuüben, so dass eine vertikale Ablenkung ($\Delta\delta_{appl}$) sondiert und unabhängig gemessen wird, um insbesondere Messungen der Form des "Kraftspektroskopiemodus" oder der Form der "Nanoindentierung" durchzuführen, ohne Aberrationen, die durch das externe Scannersystem eingeführt werden.

**11.** Verfahren nach einem oder mehr der vorhergehenden Ansprüche, **dadurch gekennzeichnet, dass** es das Anlegen an die piezoelektrische Schicht (13) einer Wechselspannung, insbesondere bei einer Resonanzfrequenz (fr; $\omega_0$) des Auslegers (18; 48) vorsieht.

**12.** Verfahren nach Anspruch 10 oder 11, **dadurch gekennzeichnet, dass** es das Ausüben einer gesteuerten Kraft ($F_{appl}$) für eine Sensoranwendung, insbesondere die Rastersondenmikroskopie im Anzapfmodus oder zur Mikroaktorik an der Probe, insbesondere einer Scanprobe im Schreibmodus aufweist.

**13.** Verfahren zur Herstellung des Bauelements nach einem der Ansprüche 1 bis 6, **dadurch gekennzeichnet, dass** es die Arbeitsgänge aufweist:

Züchten (310; 410) auf einem Substrat (11, 12) in Folge einer unteren Kontaktschicht (14b), der piezoelektrischen Schicht (13), der oberen Kontaktschicht (14a), um eine Auslegerstruktur (18; 48) zu bilden;
Auftragen (320; 420) einer Isolationsschicht (16),
Auftragen (340; 440) einer piezoresistiven Schicht (15), um eine Dehnmessvorrichtung (15a) zu bilden,
Formen (350; 450) des Auslegers (18; 48) durch ein chemisches Ätzen und Durchführen einer selektiven Entfernung (360; 460) einer Opferschicht (12) des Substrats (11, 12), um die Freigabe des Auslegers (18; 48) und eine automatische Biegung durch die Restspannung zu bewirken.

14. Verfahren nach Anspruch 13, **dadurch gekennzeichnet, dass** es die Verwendung eines SOI (Silicon On Insulator - Silizium auf Isolator) Substrats (42) aufweist, das zwischen zwei massiven Halbleiterschichten eine Isolier-Stoppschicht (42a) umfasst, und dadurch, dass die Arbeitsgänge zum Formen (450) des Auslegers (18; 48) durch chemisches Ätzen und Durchführen einer selektiven Entfernung (460) einer Opferschicht (12) des Substrats (11, 12) das Durchführen des Ätzens (430; 450) an einer unteren Oberfläche des SOI Substrats aufweist, um eine Spitze (41) des Auslegers (48) und eine Trägerstruktur (44) des Auslegers (45) zu definieren.

## Revendications

1. Dispositif micro-électromécanique électro-actif du type cellule à poil artificiel, comprenant une structure de cil mobile comportant un substrat (11, 12 ; 42) et un porte-à-faux (18 ; 48), en partie ou entièrement en matériau piézoélectrique, soumis à une flexion ou à une déformation en réponse à l'action d'une force externe et/ou d'une tension ($V_{appl}$) appliquée, ledit porte-à-faux (18 ; 48) comportant une multicouche (13, 14a, 14b, 16) induisant une géométrie de contrainte par l'intermédiaire d'un gradient de contrainte résiduelle par rapport à l'épaisseur des couches comprises dans ladite multicouche (13, 14a, 14b, 16) dans laquelle une partie (19) dudit porte-à-faux (18 ; 48) se situe à l'extérieur d'un plan défini par le substrat (11, 12 ; 42), dans lequel ledit porte-à-faux (18 ; 48) est associé à un élément piézo-résistif (15), en particulier fait d'un matériau piézo-résistif, configuré pour mesurer la flexion ou la déformation dudit porte-à-faux (18 ; 48).

2. Dispositif selon la revendication 1, **caractérisé en ce que** ledit élément piézo-résistif (15) comporte une couche piézo-résistive comprenant une partie (15b) formée pour fonctionner comme un dispositif à jauge de contrainte.

3. Dispositif selon la revendication 1 ou 2, **caractérisé en ce que** ledit porte-à-faux (18 ; 48) comporte :

une couche piézoélectrique (13), comprise dans une structure de sandwich de couches métalliques de contact (14a, 14b) adaptées à fonctionner comme des électrodes pour appliquer une tension sur ladite couche piézoélectrique (13), et
une couche isolante (16) reposant sur une couche supérieure (14a) desdites couches de contact (14a, 14b), et **en ce que**
ladite couche piézo-résistive (15) est placée sur ledit porte-à-faux (18) dans une zone soumise à une flexion ou à une déformation.

4. Dispositif selon l'une quelconque des revendications précédentes, **caractérisé en ce que** ledit élément piézo-résistif (15) est compris dans une structure à pont de Wheatstone d'éléments piézo-résistifs conçus pour compenser des variations thermiques.

5. Dispositif selon l'une quelconque des revendications précédentes, **caractérisé en ce que** les couches de contact (14a, 14b) de la couche piézoélectrique (13) et les contacts (15a) de la couche piézo-résistive (15) sont associés aux moyens formant circuit (30) configurés pour commander des signaux piézoélectriques (Vp), en particulier une tension appliquée ($\Delta V_{appl}$) appliquée sur ladite couche piézoélectrique (13), et pour mesurer les valeurs de piézo-résistance (R) de ladite couche piézo-résistive (15).

6. Dispositif selon l'une quelconque des revendications précédentes, **caractérisé en ce qu'**une partie suspendue (19) dudit porte-à-faux (48) comporte une poutre de support (44) obtenue par le substrat (42), ladite poutre de support (44) comportant une pointe (41) à l'extrémité.

7. Procédé de détection des quantités physiques pour une utilisation avec le dispositif selon l'une quelconque des revendications 1 à 6, **caractérisé par**
la soumission dudit porte-à-faux (18 ; 48) à l'action d'une force conçue pour provoquer la flexion ou la déformation de ce dernier,

la mesure d'une variation de résistance relative (($\Delta R/R$)) correspondante de la couche piézo-résistive (15), l'application, avant ou pendant ladite opération de mesure, d'une tension ($\Delta V_{appl}$) additionnelle sur ladite couche piézoélectrique (13).

8. Procédé selon la revendication 7, **caractérisé en ce qu'**il comprend l'application d'une tension ($\Delta V_{appl}$) additionnelle sur ladite couche piézoélectrique (13) pour décaler un point de travail initial ($V_0$, ($\Delta R/R)_0$)) respectif et le réglage d'une plage dynamique et/ou un intervalle de sensibilité ou une plage de mesures.

9. Procédé selon la revendication 7 ou 8, **caractérisé en ce que** ledit porte-à-faux (48) est compris dans une sonde (60) de microscopie en champ proche.

10. Procédé selon la revendication 9, **caractérisé en ce qu'**il comprend l'application d'une tension ($\Delta V_{appl}$) sur ladite multicouche du porte-à-faux (48) pour appliquer une force commandée ($F_{appl}$) sur un échantillon à sonder et la mesure de manière indépendante une déflexion verticale ($\Delta\delta_{appl}$) afin, en particulier, d'effectuer des mesures du type « mode de spectroscopie de force » ou du type « nano-indentation » sans les aberrations introduites par le système de scanner externe.

11. Procédé selon l'une ou plusieurs des revendications précédentes, **caractérisé en ce qu'**il envisage l'application sur la couche piézoélectrique (13) d'une tension alternée, en particulier à une fréquence de résonance (fr ; $\omega_0$) dudit porte-à- faux (18 ; 48).

12. Procédé selon la revendication 10 ou 11, **caractérisé en ce qu'**il comprend l'application d'une force commandée ($F_{appl}$) pour une application de détection, en particulier une microscopie en champ proche en mode prélèvement, ou pour un micro-actionnement sur l'échantillon, en particulier une sonde de balayage en mode écriture.

13. Procédé de fabrication du dispositif selon l'une quelconque des revendications 1 à 6, **caractérisé en ce qu'**il comprend les opérations de :

accroissement (310 ; 410) sur un substrat (11, 12) de manière séquentielle d'une couche de contact inférieure (14b), de la couche piézoélectrique (13), de la couche de contact supérieure (14a), afin de former une structure en porte-à-faux (18 ; 48),
dépôt (320 ; 420) d'une couche isolante (16),
dépôt (340 ; 440) d'une couche piézorésistive (15) formant un dispositif à jauge de contrainte (15a),
formation (350 ; 450) dudit porte-à-faux (18, 48) par gravure chimique et mise en oeuvre d'une élimination (360 ; 460) sélective d'une couche sacrificielle (12) dudit substrat (11, 12) pour provoquer la libération du porte-à-faux (18 ; 48) et une flexion automatique due à la contrainte résiduelle.

14. Procédé selon la revendication 13, **caractérisé en ce qu'**il comprend l'utilisation d'un substrat SOI (silicium sur isolant) (42), comprenant, entre deux couches semiconductrices volumiques, une couche isolante de butée (42a) et **en ce que** lesdites opérations de mise en en forme (450) dudit porte-à-faux (18 ; 48) par gravure chimique et de mise en oeuvre d'une élimination (460) sélective d'une couche sacrificielle (12) dudit substrat (11, 12) comprennent la mise en oeuvre d'une gravure (430, 450) sur une surface inférieure dudit substrat SOI pour définir une pointe (41) du porte-à-faux (48) et une structure de support (44) du porte-à-faux (45).

Fig. 1

EP 2 617 074 B1

10

16

15a

14a

15b

14b

18

13

Fig. 2

Fig. 3

EP 2 617 074 B1

Fig. 4

EP 2 617 074 B1

Fig. 5

Fig. 6

EP 2 617 074 B1

Fig. 7

Fig. 8

$$(\Delta R/R)_0' = [(18\ \underline{k}\ \beta\ (GF)\ L^3\ d_{31}) / (W)] \cdot [\Theta / (E_{eq}\ t_{eq}^2)^2] \cdot \Delta V_{appl} + (\Delta R/R)_0$$

$(\Delta R/R)_0'$

DR

$(V_0', (\Delta R/R)_0')$

$f(\Delta V_{appl}) = (\Delta R/R)_0' - (\Delta R/R)_0$

$(V_0, (\Delta R/R)_0)$

$\Delta V_{appl}$

DV

Fig. 9

EP 2 617 074 B1

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005051515 A1

- US 20090301196 A

**Non-patent literature cited in the description**

- **ZHANG et al.** *Sensors and Actuators,* 2010, vol. A 158, 273-279